# EUROPEAN PATENT APPLICATION

(11) **EP 1 473 763 A1**
(43) Date of publication of application: **03.11.2004**
(21) Application number: 03425281.7
(22) Date of filing: 30.04.2003
(51) Int. Cl.: H01L 21/48, H01L 23/495

(54) **Manufacturing method of a lead frame for power semiconductor electronic devices, separating the leads and downsetting the die pad in one step**

(71) Applicant: STMicroelectronics S.r.l., 20041 Agrate Brianza (Milano) (IT)
(72) Inventor: Deodato, Claudio, 20093 Cologno Monzese, Milano (IT); Tiziani, Roberto, 20014 Nerviano, Milano (IT)
(74) Representative: Botti, Mario

(57) **Abstract**

A method for manufacturing semiconductor electronic devices (1) comprising the step of:
- forming, from a plane metallic foil defining a lie plane, a supporting frame (2) comprising a mount pad (3) for said devices and corresponding leads (4) being short-circuited to said mount pad (3),
characterised in that it comprises the steps of:
- downsetting said mount pad (3) on a plane being parallel to said lie plane keeping at least a group of leads (4) on said lie plane and separating by shearing said mount plane (3) from said group of leads (4),
- mounting a die on a first surface of said mount pad (3),
- forming the electrical connections between said die and said group of leads (4),
- encapsulating said frame (2) in a protective package (6) so as to leave the second surface of said mount pad (3), being opposite to said first surface, exposed from said protective package (6).

## Description

### Field of application

The present invention relates to a manufacturing method for power semiconductor electronic devices encapsulated in a protective package.

More specifically, the invention relates to a method for manufacturing power semiconductor electronic devices.

The invention also relates to a method for manufacturing frames for semiconductor electronic devices.

The invention also relates to a frame for power electronic devices comprising:
- a plurality of leads located on a first plane,
- a mount pad downset with respect to said first plane and comprised in a second plane.

The invention particularly relates, but not exclusively, to a method for manufacturing power containers for power semiconductor electronic devices, the following description is made with reference to this field of application for convenience of illustration only.

### Prior art

As it is well known, semiconductor electronic devices comprise an electronic circuit manufactured in a semiconductor material chip, so-called "die", with a surface of a few square millimetres. Traditionally, the electronic circuit is monolithically integrated in the die. The die, for being thermally and mechanically protected, is thus coated with a casing or package.

These devices require, for their electrical connection to an external circuit, suitable support and electrical interconnection means. To this purpose, a conductive leadframe is used, which is composed of a thin wrought metallic plate comprising a die mount pad, also called die pad, substantially rectangular, whereon the die and a plurality of narrow strips are fixed and insulated from the mount pad, representing electrical connectors or leads.

The plurality of narrow strips have an end electrically connected to the integrated circuit, through wires welded between each end and corresponding integrated circuit pads, while the opposite free end of the electrical connectors projects outside the package to form the so-called electrical interconnection pins of the device.

In the case of power electronic devices which will be analysed in the following description, i.e. of devices being capable of producing a relatively high amount of heat, reference is commonly made to so-called power packages. This term means a device being capable of dissipating heat.

A first solution to transfer outside the heat produced during the integrated circuit operation is to couple the frame, for example of a single-thickness material, to a heat-sink element.

The heat-sink element is simply a metallic element, or however a good flattened cylinder or parallelepiped-shaped heat conductor, with a mass being considerably higher than the die one, i.e. of the electronic device fixed to the frame by riveting or welding.

Traditionally, in a power package, the heat-sink element has a heat-sink element surface being exposed from the package while the opposite larger surface and all side surfaces are insulated i.e. coated with the package plastic material.

Although advantageous under many aspects, this first solution has several drawbacks. In fact, to perform the riveting or welding it is necessary to insert some mechanical steps in the power package manufacturing process involving a considerable increase in the final device costs.

A second solution to increase the frame thickness in correspondence of the portion being exposed from the package implies the use of a double-thickness material to manufacture the frame.

In particular, the frame is formed by a metallic plate comprising a first portion of a first thickness equal to the final thickness of the portion being exposed from the package, and a second portion of a second thickness equal to the lead final thickness.

This second reduced-thickness portion is obtained by milling the starting metallic plate.

Although responding to the scope, also this solution has some drawbacks. In fact this solution involves a considerable material waste and a series of additional operations in the manufacturing process which increase the difficulty and the corresponding costs.

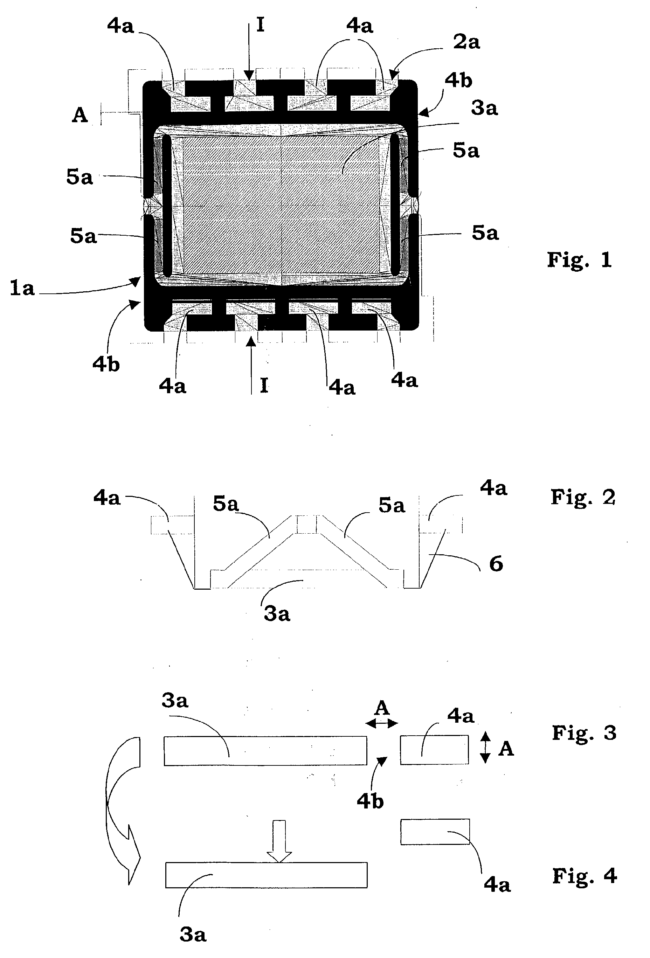

A further solution for manufacturing a power semiconductor electronic device 1a is shown in figures 1 to 4 and it implies the use of a not-plane frame 2a, i.e. having a mount pad 3a being downset with respect to the plane on which leads 4a lie. The frame 2a also comprises arms or braces 5a to physically support the mount pad 3a.

This downsetting is thus obtained by simply deforming the plane metal foil wherein the mount pad 3a and leads 4a are manufactured. These leads 4a, are physically separated from the mount pad 3a through an size opening 4b formed in the plane metallic foil as shown in figures 3 and 4.

After mounting the die on the mount pad 3a, the so-obtained frame 3a is encapsulated in a plastic package 6a so as to leave a surface of the mount pad 3a exposed from the plastic package 6a.

Although responding to the scope, also this solution has some drawbacks.

In fact there are some very strict design rules to correctly engrave the metallic foil wherein the mount pad 3a and the leads 4a of the frame 2a are formed.

In particular, it is impossible to open the foil openings 4b whose size A is smaller than the thickness of the foil itself.

Therefore the minimum distance which must exist in traditional frames 2a between the mount pad 3a and leads 4a is equal to the size A.

Although this manufacturing technique is low-cost, the mount pad 3a size is limited by these design rules.

The technical problem underlying the present invention is to provide a manufacturing method for power semiconductor electronic devices encapsulated in a protective package allowing a big-size die to be located in the protective package without increasing traditional manufacturing process costs.

### Summary of the invention

The solution idea underlying the present invention is to modify the frame so that leads are initially short-circuited to the mount pad in order to increase the size of the pad itself. The physical separation between the leads and the mount pad is performed in the downsetting step of the mount pad with respect to the leads. This downsetting is performed by shearing the metallic foil between the leads and the mount pad.

On the basis of this solution idea the technical problem is solved by a method as previously indicated and defined in the characterising part of claim 1.

The problem is also solved by a method for manufacturing frames as previously indicated and defined in the characterising part of claim 3.

The problem is also solved by a frame as previously indicated and defined in the characterising part of claim 4.

The features and advantages of the device according to the invention will be apparent from the following description of an embodiment thereof given by way of non limiting example with reference to the attached drawings.

### Brief description of the drawings

In the drawings:
Figure 1 is a view from above of a power package manufactured according to the prior art;
Figure 2 is a side view of a frame used in the power package of figure 1;
Figures 3 and 4 are sectional views along the line I-I of the frame used during the manufacturing process of the power package of figure 1;
Figure 5 is an exploded view from above of a power package manufactured according to the invention;
Figure 6 is a side view of a frame used in the power package of figure 5;
Figures 7 and 8 are sectional views along the line II-II of the frame used during the manufacturing process of the power package of figure 5;
Figures 9 and 10 are views from above of an alternative embodiment of a power package manufactured according to the invention during manufacturing steps;
Figure 11 is a side view of a frame used in the power package of figure 10;
Figure 12 is a photographic representation of the frame of figure 11.

### Detailed description

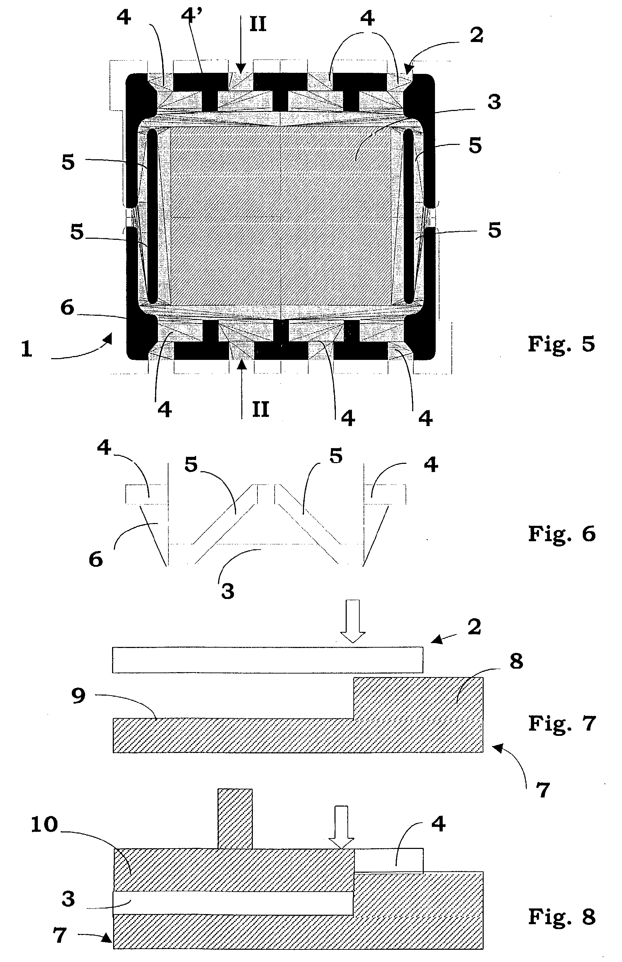

With reference to figures 5 to 8, a method for manufacturing semiconductor electronic devices encapsulated in a protective package is described.

In particular, with reference to figure 5, an electronic power device 1 is shown, which comprises a frame 2 being partially encapsulated in an insulating protective package 6, for example of plastic material. This frame 2 comprises a mount pad 3 whereon a die comprising an integrated circuit and a plurality of leads 4 are fixed, which are electric connectors of the electronic device 1 and of the arms 5 to physically support the mount pad 3.

According to the invention the frame 2 is formed in a plane conductive foil defining a lie plane, for example metallic, wherein the plurality of leads 4 are formed, which are at first physically connected to a mount pad 3 as shown in figure 5.

Leads are separated from each other by openings 4' formed in the plane conductive foil.

The mount pad 3 is thus separated by means of the method according to the invention from the leads 4 and downset on a parallel plane to the lie plane wherein leads 4 lie. Arms 5 ensure the physical support of the mount pad 3.

Advantageously, in the electronic device 1 manufactured according to the invention the external wire of the mount pad 3 is substantially aligned along the vertical of the lead 4 inner wire as shown in figure 6.

The method for manufacturing semiconductor electronic devices 1 according to the invention is now described in detail.

In the method according to the invention a frame 2 is formed, in a plane conductive foil defining a lie plane, comprising a substantially rectangle-shaped mount pad 2 and a plurality of leads 4 laterally projecting from the mount pad 2. Leads 4 are thus short-circuited to the mount pad 2.

The plane conductive foil now rests on a matrix 7 equipped with a peripheral portion 8 being elevated with respect to a central portion 9. The central portion 9 has substantially the same dimension as the mount pad 3.

A punch 10 having substantially the same size as the central portion 9 abuts against the plane conductive foil in correspondence with the central portion 9. A pressure is thus exerted on the punch 10 so that the mount pad 3 is separated by shearing from the frame 2 portion comprising the leads 4 abutting thus against the matrix central portion 9 as shown in figure 8.

The frame 2 resulting therefrom is no more plane, but the mount pad 3 thereof is downset on a plane being parallel to the lie plane whereon leads 4 lie.

It results therefore that the internal wire of the leads 4 is substantially aligned along the vertical of the external wire of the mount pad 3.

The process for manufacturing semiconductor electronic devices then continues with the conventional process steps of:
- mounting a die on a surface of the mount pad 3,
- forming the electrical connections between the die and the leads 4,
- encapsulating the frame 2 in a plastic package 6 so as to leave the second surface of said mount pad 3 being opposite to the first surface exposed from the plastic package 6.

Although figures have shown a frame 2 wherein the leads are only on two sides, the present invention can be advantageously used also for frames having the leads or a group of leads only on one side or on four sides.

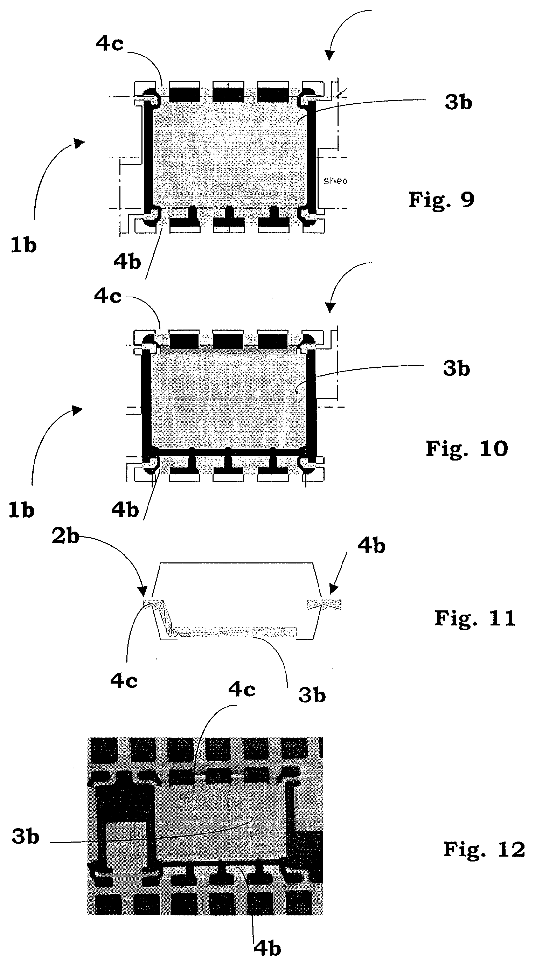

In particular, with reference to figures 9 to 12, a method for manufacturing electronic devices is described, which comprises a supporting frame 2b formed in a plane conductive foil defining a lie plane, comprising a substantially rectangle-shaped mount pad 2b and two groups of leads 4b, 4c laterally projecting on opposite sides of the mount pad 2b. Leads 4b, 4c are thus short-circuited to the mount pad 2b as shown in figure 9.

The plane conductive foil thus rests on a matrix equipped with a peripheral portion being elevated with respect to a central portion.

A punch abuts against the plane conductive foil in correspondence with the central portion. A pressure is thus exerted on the punch so that the mount pad 3 is separated by shearing only from a first group of leads 4b.

On the contrary, the mount pad 3 is connected to the second group of leads 4c, and in downsetting with respect to the first group of leads 4b it shifts towards this second group of leads 4c as shown in figures 10 and 11.

The frame 2b resulting therefrom is no more plane, but the mount pad 3b thereof is downset on a plane being parallel to the lie plane whereon leads 4b and 4c lie.

The process for manufacturing semiconductor electronic devices thus continues with the traditional process steps of mounting the die on the frame, of electrically connecting the leads 4b to the die and of encapsulating the frame 2b in a plastic package 6b.

Advantageously, in this embodiment, the mount pad 4b is still short-circuited to the second group of leads 4c, after the downsetting step. This second group of leads 4c can thus be used for connecting the mount pad 4b to ground.

In conclusion, if using the same frame 2, 2b as in the traditional downsetting technique, the mount pad 3, 3b according to the invention is larger than prior art pads 3a since the leads 4, 4b, effective to form the die electrical connection, are not physically separated from the mount pad 3 before downsetting.

In fact in traditional manufacturing processes leads 4a are separated from the mount pad 3a before downsetting and the mount pad 3a is downset only by deforming the plane metallic foil.

With the method according to the invention the mount pad 3, 3b is separated by shearing from leads 4, 4b and thus downset in a single operation.

Therefore this foil portion, which was eliminated in the prior art, is advantageously used in the device 1 according to the invention, to enlarge the mount pad 3, 3b.

It is therefore available, for the final device 1, both a larger mount surface and a larger exposed portion for the integrated circuit cooling.

## Claims

1. A method for manufacturing semiconductor electronic devices (1, 1b) comprising the step of:
- forming, from a plane metallic foil defining a lie plane, a supporting frame (2, 2b) comprising a mount pad (3, 3b) for said devices and corresponding leads (4, 4b, 4c) being short-circuited to said mount pad (3, 3b),
**characterised in that** it comprises the steps of:
- down setting said mount pad (3, 3b) on a plane being parallel to said lie plane keeping said leads (4, 4b, 4c) on said lie plane and separating by shearing said mount plane (3, 3b) from at least a group of leads (4, 4b),
- mounting a die on a first surface of said mount pad (3, 3b),
- forming the electrical connections between said die and said at least one group of leads (4, 4b),
- encapsulating said frame (2, 2b) in a protective package (6, 6b) so as to leave the second surface of said mount pad (3, 3b), being opposite to said first surface, exposed from said protective package (6, 6b).

2. A method for manufacturing electronic devices (1) according to claim 1, **characterised in that** said downsetting step of said mount pad (3) comprises the steps of:
- resting said plane foil on a matrix (7) comprising a central portion (9) located in said lie plane and a peripheral portion (8) having the upper surface located in said parallel plane,
- abutting a punch (10) having substantially the same size as said mount portion (3) on said foil in correspondence with said central portion (9).
- exerting a pressure on the punch (10) so as to separate by shearing the foil, leaving the leads (4) in said lie plane and bringing said mount pad (3) on said parallel plane.

3. A method for manufacturing frames for power electronic devices (1, 1b) encapsulated in protective packages comprising the steps of:
- manufacturing a supporting frame (2, 2b) comprising a mount pad (3, 3b) and respective leads (4, 4b, 4c) being short-circuited to said mount pad (3, 3b),
**characterised in that** it comprises the steps of:
- downsetting said mount pad (3, 3b) on a plane being parallel to a lie plane wherein said leads (4, 4b, 4c) lie separating by shearing said mount pad (3, 3b) by at least one group of said leads (4, 4b).

4. A frame (2) for power electronic devices comprising:
- a plurality of leads (4) located on a lie plane,
- a mount pad (3) being downset with respect to said lie plane and comprised in a plane being parallel to said lie plane, **characterised in that** an inner wire of said leads (4) is substantially aligned along the vertical of an external wire of said mount pad (3).

5. A frame (2) for power electronic devices (1) according to claim 4, **characterised in that** the mount pad (3) is substantially rectangular.

6. A frame (2) for electronic power devices (1) according to claim 4, **characterised in that** said group of leads (4) is formed on two opposite sides of said frame (2).

7. A frame (2) for electronic power devices (1) according to claim 5, **characterised in that** said group of leads (4) is formed on the four sides of said frame (2).

8. An electronic device (1) **characterised in that** it comprises a frame (2) manufactured according to claim 3.
